# EUROPEAN PATENT APPLICATION

(11) **EP 4 842 150 A1**
(43) Date of publication of application: **18.11.2026**
(21) Application number: 26177190.1
(22) Date of filing: 07.05.2026
(51) Int. Cl.: H05K 5/02, G06K 19/077

(54) **EASY-TO-ASSEMBLE PORTABLE STORAGE DEVICE**

(30) Priority: 16.05.2025 TW 114118522
(71) Applicant: Chang, Calvinson, Alhambra, CA 91803 (US)
(72) Inventor: Chang, Calvinson, Alhambra, CA 91803 (US)
(74) Representative: Becker, Eberhard

(57) **Abstract**

An easy-to-assemble portable storage device has a main housing (10), a storage module (20), and a holder (30). The main housing (10) includes a mounting casing (11) and an end cap (12). The storage module (20) is mounted in the mounting casing (11). The holder (30) is securely mounted to the end cap (12) and a circuit board (21) of the storage module (20), and is connected with the mounting casing (11). Assembling personnel can complete assembly of the portable storage device by simply following instructions step by step without using adhesive. In addition to a lowered technical threshold, there is no need to wait 24 hours for the adhesive to cure. Accordingly, ease in assembly can be facilitated and the time spent shortened.

## Description

### 1. Field of the Invention

The present invention relates to a portable storage device, especially to a portable storage device that is easy to assemble.

### 2. Description of the Prior Art(s)

A rewritable portable data storage device uses flash memory as the storage medium for digital data. The portable data storage device is small in size, light in weight and easy to carry, and thus is commonly used to store digital data and transfer the digital data from one computer to another.

The portable data storage device substantially has a hollow housing and a storage module mounted in the housing. The storage module has an electrical connector protruding to an exterior of the housing. Common data transmission interfaces used by the electrical connector may be a USB (Universal Serial Bus) Type-A interface, a USB Type-C interface, or a Lightning interface exclusively introduced by Apple Inc.

The housing of a conventional data storage device comprises a mounting casing and an end cap. When assembling, assembling personnel places the storage module into the mounting casing from an open end of the mounting casing to make the electrical connector of the storage module protrude out of the mounting casing from another end of the mounting casing. Then adhesive is dispensed on an outer peripheral surface of the end cap and the end cap is placed in the open end of the mounting casing. After waiting for about 24 hours for the adhesive to cure, the end cap is securely connected with the mounting casing with the adhesive, thereby encapsulating the storage module in the mounting casing.

However, in order to facilitate ease in carrying, an overall size of the portable storage device is small and the end cap is also a relatively small component. Therefore, an amount of the adhesive applied on the outer peripheral surface of the end cap has to be precisely controlled. If excessive, the adhesive would overflow when the end cap is placed into the mounting casing; if insufficient, the end cap would not be firmly mounted in the mounting casing.

Since the end cap is small in size, it is not feasible to dispense the adhesive on the outer peripheral surface of the end cap by automation, and it is also difficult to dispense the adhesive manually. This means a high technical threshold for the assembling personnel's experience and skills in adhesive-dispensing, and the task cannot be entrusted to inexperienced or less skilled personnel. Moreover, it takes about 24 hours to wait for the adhesive to cure when using the adhesive to securely connect the end cap and the mounting casing. Consequently, the overall assembly time of the conventional portable storage is greatly prolonged.

The main objective of the present invention is to provide an easy-to-assemble portable storage device. The portable storage device comprises a main housing, a storage module, and a holder.

The main housing includes a mounting casing and an end cap. The mounting casing has: an open end; and an outer engaging portion formed on a peripheral sidewall of the mounting casing. The end cap is mounted in the open end of the mounting casing and has two sidewalls oppositely defined on the end cap.

The storage module is mounted in the mounting casing of the main housing and has a circuit board and a first electrical connector. The circuit board has: a front end portion; a rear end portion positioned toward the open end of the mounting casing; and two hooking notches formed in two opposite side edges of the circuit board respectively. The end cap is mounted around the rear end portion of the circuit board. The first electrical connector is mounted on the front end portion of the circuit board and is mounted through the mounting casing to protrude to an exterior of the main housing.

The holder is securely mounted on the end cap and has a main plate and two side plates.

The main plate has an inner engaging portion corresponding in position to and engaging with the outer engaging portion of the mounting casing.

The two side plates are bent from two opposite sides of the main plate and extend in the same direction. The two side plates are overlapped with and snap-fitted on the two sidewalls of the end cap respectively and are disposed beside the two side edges of the circuit board respectively. Each of the side plates has a mounting hole formed through the side plate. A front end portion of the side plate is formed between the mounting hole and the front end edge of the side plate and engages in a corresponding one of the hooking notches of the circuit board. The rear end portion of the circuit board protrudes in the mounting holes of the two side plates.

With the holder connecting the end cap, the circuit board and the mounting casing, the assembling personnel can complete assembly of the portable storage device by simply following the instructions step by step without using adhesive. In addition to a lowered technical threshold, there is no need to wait 24 hours for the adhesive to cure. Accordingly, ease in assembly can be facilitated and the time spent thereon shortened.

### IN THE DRAWINGS:

Fig. 1 is a perspective view of an easy-to-assemble portable storage device in accordance with the present invention;
Fig. 2 is a partially exploded perspective view of the portable storage device in Fig. 1;
Fig. 3 is an exploded perspective view of a storage module, a holder and an end cap of the portable storage device in Fig. 1;
Fig. 4 is a perspective view of the storage module, the holder and the end cap of the portable storage device in Fig. 1;
Fig. 5 is a perspective view of the portable storage device in Fig. 1, omitting a protective swivel;
Fig. 6 is a cross-sectional side view of the portable storage device in Fig. 1;
Fig. 7 is a bottom exploded perspective view of the portable storage device in Fig. 1; and
Fig. 8 is a top exploded perspective view of the portable storage device in Fig. 1.

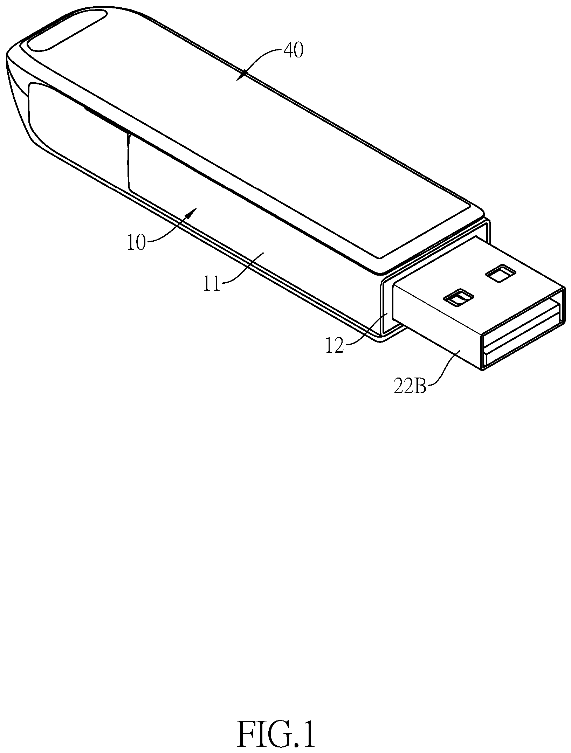

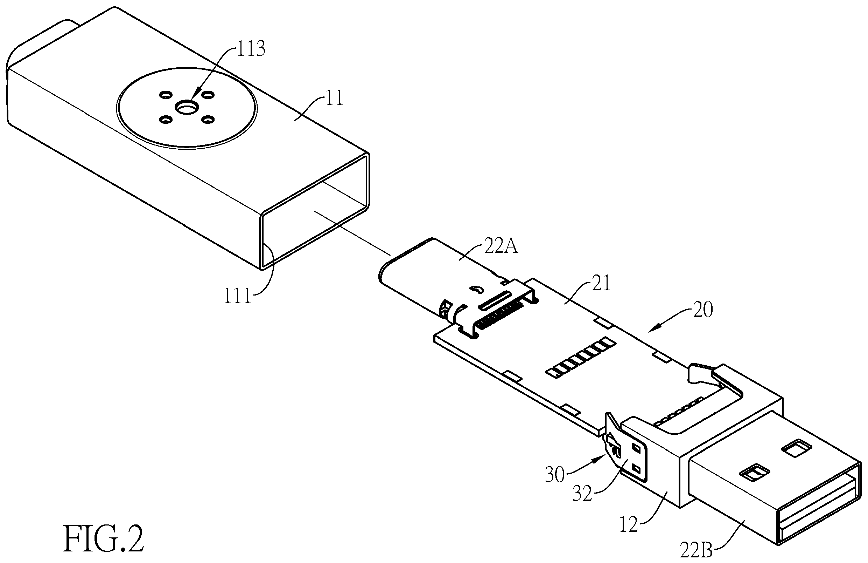

With reference to Figs. 1 and 2, an easy-to-assemble portable storage device in accordance with the present invention comprises a main housing 10, a storage module 20, a holder 30 and a protective swivel 40.

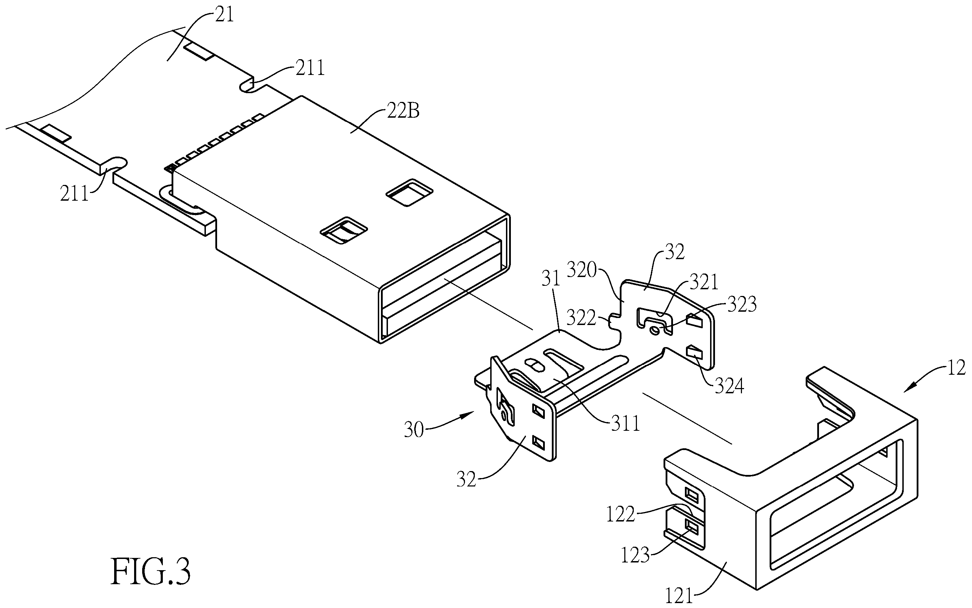

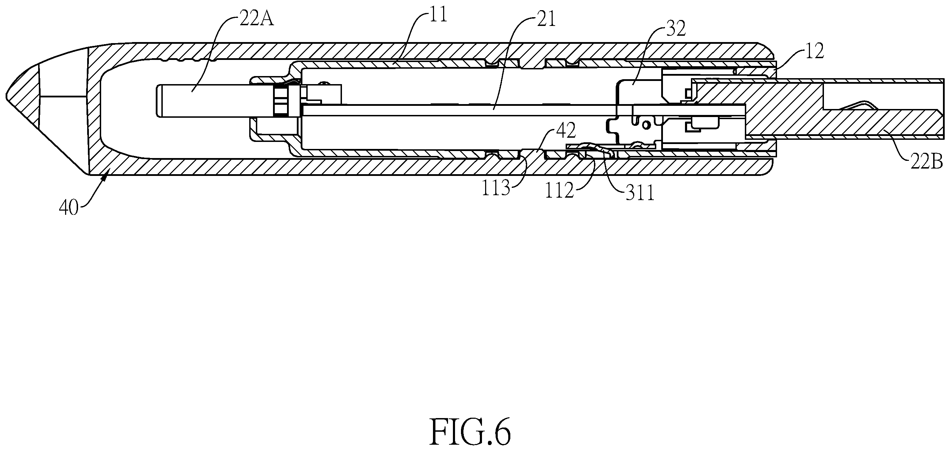

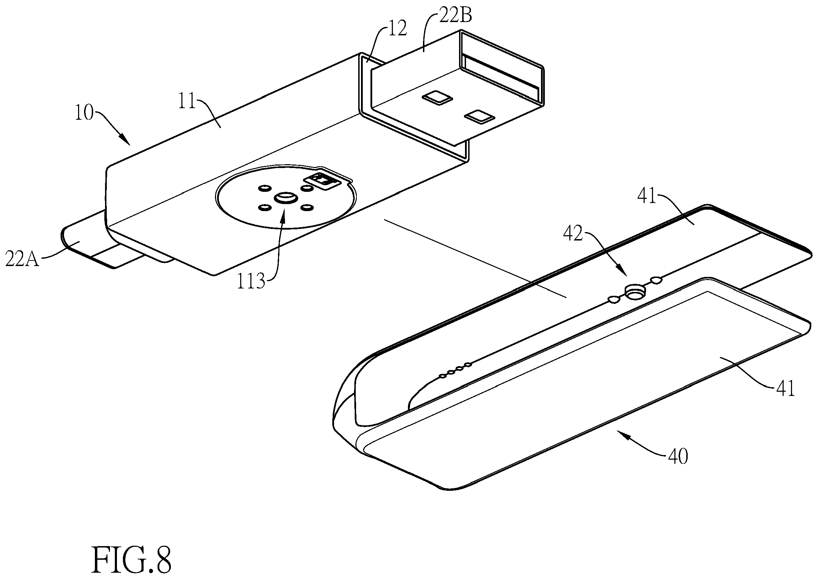

With reference to Figs. 2 and 3, the main housing 10 includes a mounting casing 11 and an end cap 12. With further reference to Figs. 6 and 8, the mounting casing 11 has a peripheral sidewall, an open end 111, an outer engaging portion 112 and two outer pivot portions 113. The outer engaging portion 112 is formed on the peripheral sidewall of the mounting casing 11. The two outer pivot portions 113 are disposed on the peripheral sidewall of the mounting casing 11, are defined oppositely on the mounting casing 11, and are coaxial.

The end cap 12 is mounted in the open end 111 of the mounting casing 11, and has two sidewalls 121, two insertion slots 122 and multiple inner positioning portions 123. The two sidewalls 121 are oppositely defined on the end cap 12. Each of the sidewalls 121 has an inner end edge facing toward an interior of the mounting casing 11. The two insertion slots 122 are formed on the two sidewalls 121 respectively. Each of the insertion slots 122 is formed through the inner end edge of a corresponding one of the sidewalls 121. Each of the inner positioning portions 123 is formed on an outer side surface of a respective one of the two sidewalls 121.

With reference to Figs. 2 and 3, the storage module 20 is mounted in the mounting casing 11 of the main housing 10, and has a circuit board 21, a first electrical connector 22A and a second electrical connector 22B. The circuit board 21 has a front end portion, a rear end portion, two side edges and two hooking notches 211. The front end portion and the rear end portion are formed as two opposite ends of the circuit board 21 respectively. The rear end portion is positioned toward the open end 111 of the mounting casing 11. The end cap 12 is mounted around the rear end portion of the circuit board 21. The side edges are formed as two opposite edges of the circuit board 21. Each of the side edges extends between the front end portion and the rear end portion. The two hooking notches 211 are formed in the two side edges of the circuit board 21 respectively and are disposed adjacent to the end cap 12 that is mounted around the rear end portion of the circuit board 21.

The first electrical connector 22A is mounted on the front end portion of the circuit board 21 and is mounted through the mounting casing 11 to protrude to an exterior of the main housing 10. The second electrical connector 22B is mounted on the rear end portion of the circuit board 21 and is mounted through the end cap 12 to protrude to the exterior of the main housing 10. The first electrical connector 22A and the second electrical connector 22B are electrically connected with circuits provided on the circuit board 21, so as to access data stored in memory chips on the circuit board 21 through the first electrical connector 22A and the second electrical connector 22B.

In the preferred embodiment, the first electrical connector 22A is a USB (Universal Serial Bus) Type-C connector and the second electrical connector 22B is a USB Type-A connector. However, it is not limited thereto. The first electrical connector 22A and the second electrical connector 22B may be different kinds of electrical connectors.

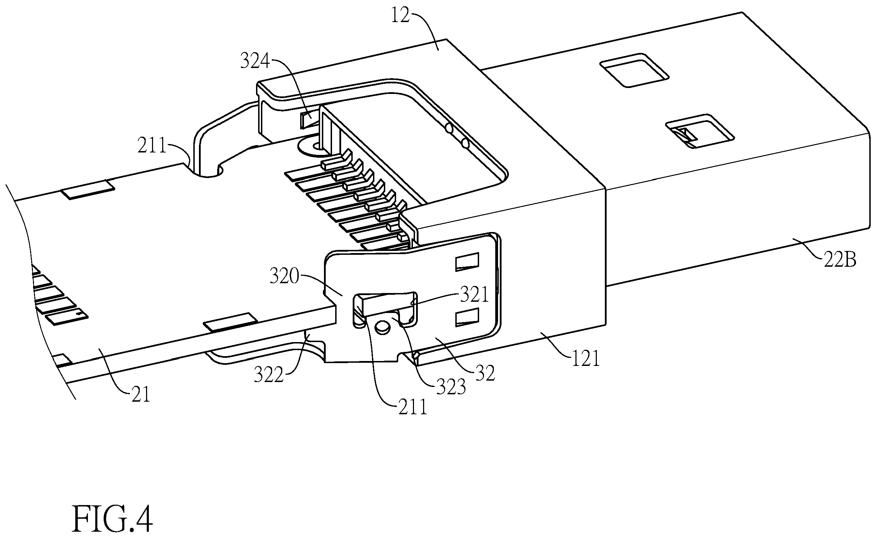

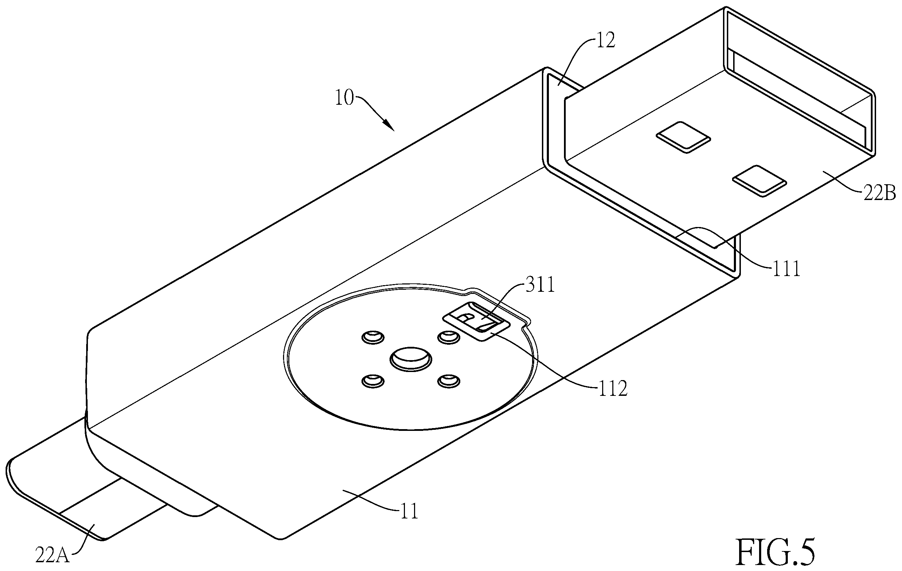

With further reference to Figs. 4 and 5, the holder 30 is securely mounted on the end cap 12, is substantially U-shaped and has a main plate 31 and two side plates 32. The two side plates 32 are bent from two opposite sides of the main plate 31 and extend in the same direction. The main plate 31 overlaps the peripheral sidewall of the mounting casing 11 and is inserted in the two insertion slots 122 of the end cap 12. The main plate 31 has an inner engaging portion 311. The inner engaging portion 311 corresponds in position to and engages with the outer engaging portion 112 of the mounting casing 11, such that a relative position of the holder 30 and the mounting casing 11 is fixed.

In the preferred embodiment, the outer engaging portion 112 of the mounting casing 11 is formed as a through hole and the inner engaging portion 311 of the main plate 31 of the holder 30 is formed as a resilient protrusion protruding in the through hole, so as to fix the relative position of the holder 30 and the mounting casing 11. However, it is not limited thereto. Alternatively, the relative position of the holder 30 and the mounting casing 11 may be fixed with the inner engaging portion 311 formed as a through hole and the outer engaging portion 112 formed as a resilient protrusion.

The two side plates 32 are overlapped with and snap-fitted on the two sidewalls 121 of the end cap 12 respectively, and are disposed beside the two side edges of the circuit board 21 respectively. Each of the side plates 32 has a front end edge, a mounting hole 321, a front abutting protrusion 322, an inner abutting protrusion 323, and at least one outer positioning portion 324. The mounting hole 321 is formed through the side plate 32. A front end portion 320 of the side plate 32 is formed between the mounting hole 321 and the front end edge of the side plate 32 and engages in a corresponding one of the hooking notches 211 of the circuit board 21. The rear end portion of the circuit board 21 protrudes in the mounting holes 321 of the two side plates 32. Thus, the holder 30 and the circuit board 21 are securely connected with each other.

The front abutting protrusion 322 protrudes from the front end edge of the side plate 32 and abuts on the circuit board 21. The inner abutting protrusion 323 protrudes from a hole edge defined around the mounting hole 321 of the side plate 32 and abuts on the circuit board 21. With the front abutting protrusion 322 and the inner abutting protrusion 323, the holder 30 and the circuit board 21 can be further firmly connected with each other. The at least one outer positioning portion 324 is formed on an inner side surface of the side plate 32 and is connected with the inner positioning portion 123 on a corresponding one of the sidewalls 121 of the end cap 12 through a concave-convex structure, such that the side plates 32 of the holder 30 can be firmly connected with the end cap 12.

In the preferred embodiment, each of the inner positioning portions 123 of the end cap 12 is formed as a recess and each of the outer positioning portions 324 on the side plates 32 of the holder 30 is formed as a protrusion. The recess and the protrusion engage with each other, such that the side plates 32 of the holder 30 and the end cap 12 are connected with each other. However, it is not limited thereto. Alternatively, each of the outer positioning portions 324 on the side plates 32 of the holder 30 may be formed as a recess and each of the inner positioning portions 123 of the end cap 12 may be formed as a protrusion. The side plates 32 of the holder 30 and the end cap 12 are also connectable with each other in this way.

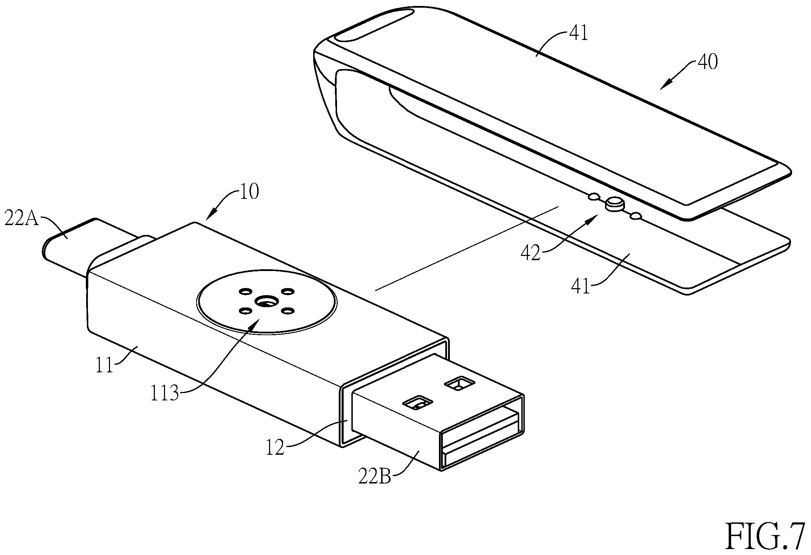

With further reference to Figs. 7 and 8, the protective swivel 40 is U-shaped and has two elongated side panels 41 and two inner pivot portions 42. An end of one of the side panels 41 is connected with the end of the other one of the side panels 41 to form a closed end of the protective swivel 40. Each of the side panels 41 has an inner sidewall. The two inner pivot portions 42 are disposed on the inner sidewalls of the two side panels 41 respectively and are pivotally connected with the outer pivot portions 113 of the mounting casing 11 respectively.

Thus, the protective swivel 40 is able to rotate around the outer pivot portions 113 of the mounting casing 11, and the closed end of the protective swivel 40 is able to selectively cover the first electrical connector 22A or the second electrical connector 22B. Accordingly, the electrical connector (e.g., the first electrical connector 22A) that is temporarily not in use can be stored in the protective swivel 40, and the electrical connector (e.g., the second electrical connector) that is exposed can be used to plug into a corresponding connector on a computer.

To assemble the portable storage device, the holder 30 is first securely mounted on the rear end portion of the circuit board 21, and then the end cap 12 is mounted onto the rear end portion of the circuit board 21 with the two sidewalls 121 of the end cap 12 inserted between the two side plates 32 of the holder 30 and the two side edges of the circuit board 21, such that the two side plates 32 of the holder 30 are snap-fitted on the two sidewalls 121 of the end cap 12 respectively and the end cap 12 is securely mounted on the rear end portion of the circuit board 21. Then the end cap 12, the holder 30 and the storage module 20 that are assembled together are being moved into the mounting casing 11 from the open end 111 of the mounting casing 11 until the inner engaging portion 311 of the holder 30 engages with the outer engaging portion 112 of the mounting casing 11. Thus, a relative position of the holder 30 and the mounting casing 11 can be fixed.

The portable storage device as described has the following advantages. With the holder 30 connecting the end cap 12, the circuit board 21 and the mounting casing 11, the assembling personnel can complete assembly of the portable storage device by simply following the instructions step by step without using adhesive. In addition to the lowered technical threshold, there is no need to wait 24 hours for the adhesive to cure. Accordingly, ease in assembly can be facilitated and the time spent thereon shortened.

## Claims

1. A portable storage device comprising:
a main housing (10) including:
a mounting casing (11) having an open end (111); and
an end cap (12) mounted in the open end (111) of the mounting casing (11) and having two sidewalls (121) oppositely defined on the end cap (12); and
a storage module (20) mounted in the mounting casing (11) of the main housing (10) and having
a circuit board (21) having a front end portion and a rear end portion positioned toward the open end (111) of the mounting casing (11); and
a first electrical connector (22A) mounted on the front end portion of the circuit board (21) and mounted through the mounting casing (11) to protrude to an exterior of the main housing (10);
the portable storage device **characterized in that**:
the mounting casing (11) of the main housing (10) has an outer engaging portion (112) formed on a peripheral sidewall of the mounting casing (11);
the end cap (12) is mounted around the rear end portion of the circuit board (21);
the circuit board (21) of the storage module (20) has two hooking notches (211) formed in two opposite side edges of the circuit board (21) respectively; and
the portable storage device further comprises a holder (30) securely mounted on the end cap (12) and having
a main plate (31) having an inner engaging portion (311), and the inner engaging portion (311) corresponding in position to and engaging with the outer engaging portion (112) of the mounting casing (11); and
two side plates (32) bent from two opposite sides of the main plate (31) and extending in the same direction; the two side plates (32) overlapped with and snap-fitted on the two sidewalls (121) of the end cap (12) respectively and disposed beside the two side edges of the circuit board (21) respectively; and each of the side plates (32) having a mounting hole (321) formed through the side plate (32), wherein a front end portion (320) of the side plate (32) is formed between the mounting hole (321) and the front end edge of the side plate (32) and engages in a corresponding one of the hooking notches (211) of the circuit board (21), and the rear end portion of the circuit board (21) protrudes in the mounting holes (321) of the two side plates (32).

2. The portable storage device as claimed in claim 1, wherein
the end cap (12) further has multiple inner positioning portions (123), and each of the inner positioning portions (123) is formed on an outer side surface of a respective one of the two sidewalls (121); and
each of the side plates (32) of the holder (30) further has at least one outer positioning portion (324) formed on an inner side surface of the side plate (32) and connected with the inner positioning portion (123) on a corresponding one of the sidewalls (121) of the end cap (12).

3. The portable storage device as claimed in claim 2, wherein the at least one outer positioning portion (324) of each of the side plates (32) of the holder (30) is connected with the inner positioning portion (123) on the corresponding one of the sidewalls (121) of the end cap (12) with a concave-convex structure.

4. The portable storage device as claimed in claim 1 or 2, wherein each of the side plates (32) of the holder (30) further has a front abutting protrusion (322) protruding from the front end edge of the side plate (32) and abutting on the circuit board (21).

5. The portable storage device as claimed in claim 1 or 2, wherein each of the side plates (32) of the holder (30) further has an inner abutting protrusion (323) protruding from a hole edge defined around the mounting hole (321) of the side plate (32), and the inner abutting protrusion (323) abuts on the circuit board (21).

6. The portable storage device as claimed in claim 1 or 2, wherein
the end cap (12) further has two insertion slots (122) formed on the two sidewalls (121) of the end cap (12) respectively, and each of the insertion slots (122) is formed through an inner end edge, which faces toward an interior of the mounting casing (11), of a corresponding one of the sidewalls (121); and
the main plate (31) of the holder (30) is inserted in the two insertion slots (122) of the end cap (12).

7. The portable storage device as claimed in claim 1 or 2, wherein
the mounting casing (11) of the main housing (10) further has two outer pivot portions (113) disposed on the peripheral sidewall of the mounting casing (11), defined oppositely on the mounting casing (11), and being coaxial; and
the portable storage device further comprises a protective swivel (40) being U-shaped and having
two elongated side panels (41), an end of one of the side panels (41) connected with the end of the other one of the side panels (41) to form a closed end of the protective swivel (40), and each of the side panels (41) having an inner sidewall; and
two inner pivot portions (42) disposed on the inner sidewalls of the two side panels (41) respectively and pivotally connected with the outer pivot portions (113) of the mounting casing (11) respectively.

8. The portable storage device as claimed in claim 1 or 2, wherein the storage module (20) further has a second electrical connector (22B) mounted on the rear end portion of the circuit board (21) and mounted through the end cap (12) to protrude to the exterior of the main housing (10).

9. The portable storage device as claimed in claim 7, wherein the storage module (20) further has a second electrical connector (22B) mounted on the rear end portion of the circuit board (21) and mounted through the end cap (12) to protrude to the exterior of the main housing (10).
